# EUROPEAN PATENT APPLICATION

(11) **EP 4 703 954 A1**
(43) Date of publication of application: **04.03.2026**
(21) Application number: 24197130.8
(22) Date of filing: 29.08.2024
(51) Int. Cl.: G06F 30/20, G05B 19/418, G06F 30/27

(54) **COMPUTER-IMPLEMENTED METHOD FOR SUPPORTING THE USER IN OPTIMIZING THE DESIGN OF A VIRTUAL ASSETS RENDERED IN A COMPUTER-SIMULATED ENVIRONMENT BASED ON USER-DETECTED SAFETY VIOLATIONS**

(71) Applicant: Siemens Aktiengesellschaft, 80333 München (DE)
(72) Inventor: RAJ, Arun, 635110 Hosur, Tamil Nadu (IN); TIWARI, Minu, 560100 Bengaluru, Karnataka (IN)
(74) Representative: HKW Intellectual Property PartG mbB

(57) **Abstract**

The method comprises importing a simulation of one or more virtual assets (104a-104n) into the computer-simulated environment (102). Further, the simulation is enriched with data corresponding to safety standards associated with the industrial environment. Further, a plurality of safety-simulation scenarios that are to be simulated in the computer-simulated environment (102) for validation of safety standards of the one or more virtual assets (104a-104n) are defined. Further, the safety-simulation scenarios are executed on the one or more virtual assets (104a-104n) to determine safety violations associated with the one or more virtual assets (104a-104n). Further, one or more inputs are received from a user for optimizing the design of the one or more virtual assets (104a-104n) to overcome the determined safety violations. Finally, the design of one or more virtual assets (104a-104n) is optimized based on the input received from the user to overcome the safety violations.

## Description

The present disclosure relates to computer simulated environments, and more particularly relates to a computer-implemented method for optimizing design of one or more virtual assets rendered in a computer-simulated environment such that the optimized design complies with safety condition for an industrial environment.

Industrial environment typically includes multiple assets such as machines, safety equipment, tools, IoT devices so on and so forth that are installed in an area. These assets are interconnected and interact with each other to enable operation of the industrial environment. Physical installation of all the assets and interconnecting them is a complex process, wherein safety of human users within the industrial environment is a crucial aspect to be considered during installation of the assets. Improper installation of assets such as machines may lead to accidents causing severe injuries to human operators in the industrial environment. Therefore, proper designing and installation of assets in an industrial environment is crucial in minimizing the accidents or mishaps in the industrial environment.

Conventionally, the industrial environments are designed using 2-dimensional drawings generated using CAD systems. The 2-dimensional drawings represent the layout of the various assets that are to be deployed in the industrial environment. Such 2-dimensional drawings do not offer an interactive experience of the industrial environment to the human operator before installing the assets. As a result, there is good chance that any flaw in the design of the industrial environment could go undetected before implementing or commissioning the industrial environment. This may result in creating an unsafe environment to human operators working in the industrial environment.

The existing solutions for validating the design of the industrial environment lack the ability to perform standard safety checks that are typically performed once the industrial environment is physically implemented. Therefore, in the existing solutions, for any lapse in adhering to the safety standards to be detected, physical implementation of the industrial environment is required which is both time-consuming and expensive.

In the light of the above, there exists a need to provide a computer-simulated industrial environment and a method for inspection of a computer-simulation of an industrial environment to detect the design flaws in the industrial environment before physical installation of the industrial environment.

Therefore, it is an object of the invention to provide a computer-implemented method for optimizing design of one or more virtual assets rendered in a computer-simulated environment such that the optimized design complies with safety condition for an industrial environment.

The term "industrial environment" as used herein refers to any environment comprising one or more assets interacting therein. The term industrial environment may refer to any building such as a factory or any type of manufacturing facility, an office building or the like, which may be populated with various entities. Herein, the term "industrial environment" refers to the whole of machineries or parts thereof which cooperate to allow a production process of any kind to be carried out. Example of industrial environment may be any industrial set-up with a plurality of assets such as a power plant, wind farm, power grid, manufacturing facility, process plants and so on. Although the present disclosure has been described generally in terms of the industrial environment being some form of a factory floor, the term "industrial environment" as used in the preferred embodiments and claims according to the present disclosure should be understood broadly to include not only factory floors, but also other indoor facilities and buildings such as hospitals, office spaces, apartments, complexes, schools, training centers, and so forth. The term "industrial environment" may also include other outdoor facilities such as a parking lot, a traffic junction, and vehicles such as airplanes, ships and trucks.

The term "assets" refers to specific objects, elements, components, or subjects in an industrial environment. In an example, the asset may be devices, machinery, robots, equipment, assembly lines, conveyors, motors, pumps, compressors, or any other mechanical, electrical, or electronic equipment, workers, operators, supervisors, in the industrial environment. In an example, the industrial environment is an office building, the one or more assets may be desks, chairs, tables, cabinets, shelves, partitions, workstations, conference room furniture, lighting fixtures, or any other furniture or fixtures typically found in an office environment. Further, the one or more assets may be equipment, or systems used in office operations, including computers, printers, scanners, copiers, telephones, projectors, audio-visual systems, networking devices, or any other technological or electronic devices commonly used in an office setting.

Throughout the present disclosure, the term "computer simulated environment" as used herein refers to three-dimensional (3D) representation of a real or physical world. It can be understood as a virtual world. The computer-simulated environment is accessible by a user, i.e., it is accessible from the real/physical world. This comprises data exchange between the computer-simulated environment and the real/physical world. In particular, the computer-simulated environment can be understood as the "metaverse". It is also possible to interact with the computer-simulated environment, i.e., to influence or use processes, components and/or functions in the computer-simulated environment. Therefore, processes in the computer-simulated environment may have direct influence on processes in the real/physical world, e.g., by modelling control processes virtually.

For example, it is possible that a user can access the computer-simulated environment via an interface, e.g., a virtual reality (VR) or augmented reality (AR) interface. The counterpart of the computer-simulated environment does not necessarily have to exist but can be for example a 3D model. It is also possible that physical forces and phenomena, e.g., gravity, are represented in a different way in the computer-simulated environment than in the real world, e.g., gravitational acceleration. For the purpose of this invention, the metaverse is comprised of one or more animated scenes being rendered corresponding to the plurality of assets interacting in the industrial environment.

The metaverse may comprise a plurality of computer-simulated components. The computer simulated components can for example be understood as a representation, in particular a 3D representation, of a real or physical component. A component can for example be a room, a building, an item, or an object. The computer-simulated component can have different functionalities/features, e.g., an access interface. The computer-simulated component further comprises data that are component-specific, e.g., sensor data of a virtual sensor, that can be retrieved for example via the access interface. An access to a computer-simulated component can for example comprise usage, modification, connection to other computer-simulated components, etc. The computer-simulated component can interact with the computer-simulated environment. For the purpose of this invention, the computer-simulated component may be one or more entities being rendered in the computer simulated collaborative environment or metaverse.

The metaverse can be realized by a hosting environment. The hosting environment can be for example be implemented as a cloud environment, an edge-cloud environment and/or on specific devices, e.g., mobile devices.

The method comprises importing, by a processing unit, a simulation of one or more virtual assets into the computer-simulated environment. The virtual assets comprise 3-dimensional computer models of assets that are implemented in the industrial environment. The processing unit may retrieve the 3-dimensional computer models of the assets and renders a simulation which is imported into the computer-simulated environment.

The method comprises enriching, by the processing unit, the simulation with data corresponding to safety standards associated with the industrial environment. The simulation of the virtual assets is supplemented by the data that is obtained from the real-world industrial environment. The data that is used to enrich the simulation may include safety standards associated with the industry.

The term "safety standards" refers to a set of established guidelines, protocols, and regulations designed to ensure the protection and well-being of workers, equipment, and the environment from potential hazards associated with industrial operations. Safety standards encompass various practices, such as the implementation of protective measures, maintenance schedules, and emergency procedures. These standards may be set by governmental or industry-specific bodies and are intended to mitigate risks related to machinery operation, chemical handling, and occupational hazards. For example, adherence to OSHA regulations in the United States, compliance with ISO 45001 for occupational health and safety management systems, or the requirement for using personal protective equipment (PPE) like helmets and gloves in certain work zones are all manifestations of safety standards. These measures collectively contribute to minimizing accidents, enhancing operational efficiency, and promoting a culture of safety within industrial settings.

The method comprises defining, by the processing unit, a plurality of safety-simulation scenarios that are to be simulated in the computer-simulated environment for validation of safety standards of the one or more virtual assets. As an example, the processing unit may receive the data pertaining to safety standards in the industry and may define safety-simulation scenarios accordingly. Also, the processing unit, may utilize pre-defined safety-simulation scenarios for validation of safety standards of the one or more virtual assets.

In one embodiment, the safety-simulation scenario may be an operation performed on the virtual assets in the computer-simulated environment by the user. Advantageously, performing such operation enables in identifying safety violations that are typically outside of the standard safety standards of the industry.

The method comprises executing, by the processing unit, the safety-simulation scenarios on the one or more virtual assets in the computer-simulated environment to determine safety violations associated with the one or more virtual assets. The safety-simulation scenarios may be performed on the virtual assets with or without human intervention to determine safety violations.

The term "safety violations" refers to actions, omissions, or conditions that fail to comply with established safety standards, regulations, or procedures, thereby posing a risk to the health and safety of workers, equipment, or the environment. Safety violations can occur due to negligence, lack of proper training, deliberate disregard for safety protocols, or insufficient maintenance of equipment.

Examples of safety violations include the installation two incompatible machines in the same zone, storing inflammable liquids near welding zone, improper storage of hazardous materials, and the operation of machinery without proper lockout/tagout procedures in place. Such violations can lead to accidents, injuries, equipment damage, and regulatory penalties.

In one aspect of the invention, the safety violations of the one or more virtual assets may be automatically determined by the processing unit based on the pre-defined safety standards associated with the industry.

In one aspect of the invention, the safety violations of the one or more virtual assets may be determined by the user based on their expertise.

The method comprises receiving, by the processing unit, one or more inputs from a user for optimizing the design of the one or more virtual assets to overcome the determined safety violations. Once the safety violations associated with the virtual assets are determined, the user may provide one or more inputs to rectify the safety violations. The inputs may relate to optimizing the design of the virtual assets such that the updated optimized design overcomes the safety violations.

The term "design" of virtual assets refers to the configuration, dimensions, installation and structuring of digital representations of physical components in an industrial environment. The virtual assets may include 3D models, digital twins, simulations, and data visualizations that replicate real-world industrial elements. The optimizing the design of virtual assets involves altering the geometric, functional, and operational characteristics of these virtual assets. For example, a virtual asset may include a digital twin of a conveyor belt system. The design of the is virtual assets (conveyor belt system) may be the number of pulleys, dimensions of the pulleys, coordinates of the base, belt design so on and so forth.

The step of receiving one or more inputs from a user for optimizing the design further comprises interacting, by the user, with the computer-simulated environment, to execute the safety-simulation scenarios on the one or more virtual assets in the computer-simulated environment. The user may interact with the one or more virtual assets in the computer-simulated environment to perform the safety-simulation scenarios on the virtual assets.

The step further comprises validating, by the user, the determined safety violations to provide one or more inputs for optimizing the design of one or more virtual assets to overcome determined safety violations. The processing unit may then automatically determine the safety violations associated with one or more virtual assets. The user may validate whether the safety violations that are determined by the processing unit are accurate. Once the safety violations that are determined are validated, the user may provide one or more inputs for optimizing the design of one or more virtual assets to overcome the determined safety violations.

The method comprises optimizing, by the processing unit, the design of one or more virtual assets based on the input received from the user. The design of virtual assets is optimized by modifying at least one design parameter of at least one virtual asset to meet the safety standards of the industrial environment.

The method comprises executing, by the processing unit, the safety-simulation scenarios on the optimized virtual assets in the computer-simulated environment to determine safety violations. The optimized virtual assets are further subjected to safety-simulation scenarios to determine safety violations. The method comprises optimizing, by the processing unit, the design of the one or more virtual assets to overcome determined safety violations by receiving inputs from the user until no safety violation is detected. The optimized design of virtual assets is further optimized if any safety violations are detected until zero safety violations are detected.

Advantageously, the design of the virtual assets may be modified to meet the safety standards before implementing or setting up the industrial environment. Therefore, any potential design flaws or safety violations in the design of the industrial environment may be identified at an early stage before physically implementing the industrial environment.

In one embodiment, the method comprises performing operations other than safety-simulation scenarios on the one or more virtual assets to optimize the one or more virtual assets. The method comprises performing, by the user, an operation on the one or more virtual assets in the computer-simulated environment. The user may perform an operation on the one or more virtual assets, wherein the operation may be any random operation that is typically performed in the industrial environment.

The method comprises receiving, by the processing unit, one or more inputs from the user corresponding to the performed operation for optimizing the design of the one or more virtual assets. The inputs may correspond to the design changes to the one or more virtual assets.

The method comprises validating, by the processing unit, inputs received from the user to determine safety violations in the design modifications corresponding to the inputs received. The processing unit determines whether the design modifications proposed by the user may result in safety violations.

The method comprises optimizing, by the processing unit, the design of one or more virtual assets based on the input received from the user if no safety violations are determined. Advantageously, the processing unit validates the input received from the user before making design modifications to the one or more virtual assets. Therefore, any potential safety violation due to human error or oversight may be avoided.

In one embodiment, the one or more virtual assets of the computer-simulated environment comprise 3-dimensional computer models of the physical assets that are deployed in the industrial environment.

In one embodiment, the method comprises authenticating, by the processing unit, the user based on a unique identifier associated with the user before providing the user the access to interact with the computer-simulated environment. The unique identifier may be a login credential corresponding to the user that allows the user to interact with the computer-simulated environment.

In one embodiment, the simulation of the one or more virtual assets is generated by retrieving and rendering 3-dimensional computer models of assets deployed in the industrial environment.

In one embodiment, the method comprises automatically recommending a modification to be made to one or more virtual assets. The method comprises analyzing, by the processing unit, the one or more inputs received from the user to validate the input with an AI module.

The method comprises recommending, by the processing unit using the AI module, a modification to be made to the virtual assets to overcome safety violations, if the AI module is trained with adequate training data. Advantageously, the AI module automatically suggests the suitable modifications to be made to the design of the virtual assets to overcome the safety violations based on the training data.

The method comprises training, the AI module, using the inputs received from the user and the modifications made to the design of one or more virtual assets, if the AI module does not have a recommendation for the inputs received from the user. Advantageously, the AI module may further learn from the inputs received from the user and the modifications made to the design to recommend design modifications in future.

In one embodiment, the method comprises determining, by the processing unit, the modification to be made to the virtual assets to overcome safety violations by correlating the safety violations with a repository of safety standards, and design standards stored in a memory. The AI module comprises historical data of design parameters and safety violations for the one or more virtual assets. The AI module correlates the historical data against the input received from the user to determine the modification to be made to the design of one or more virtual assets.

The object of the present invention is achieved by an apparatus comprising one or more processing units, and a memory unit communicatively coupled to the one or more processing units. The memory unit comprises one or modules stored in the form of machine-readable instructions executable by the one or more processing units. The one or more modules are configured to perform method steps described above.

The object of the present invention is achieved by a system comprising a computer-simulated environment, a communication network communicatively coupled to the computer-simulated environment, and an apparatus communicatively coupled to the communication network and the computer-simulated environment. The computer-simulated environment comprises one or more virtual assets. The apparatus is configured for optimizing design of one or more virtual assets rendered in the computer-simulated environment such that the optimized design complies with safety standards defined for an industrial environment as described above.

The object of the present invention is achieved by a computer-program product having machine-readable instructions stored therein, which when executed by a processor, cause the processor to perform a method as described above.

The object of the present invention is also achieved by a computer-readable storage medium comprising instructions which, when executed by a computer, cause the computer to perform a method as described above.

The present invention is further described hereinafter with reference to illustrated embodiments shown in the accompanying drawings, in which:
- FIG 1: illustrates a block diagram of a system 100 for optimizing design of one or more virtual assets (104a-104n) rendered in a computer-simulated environment 102 such that the optimized design complies with safety condition for an industrial environment;
- FIG 2: an exemplary illustration of a user performing an operation in the computer simulated environment, 102 according to an embodiment of the present invention;
- FIG 3: illustrates a block diagram of an exemplary apparatus 108 for optimizing design of one or more virtual assets rendered in a computer-simulated environment 102, according to an embodiment of the present invention;
- FIG 4: illustrates an architecture 400 of the system for optimizing design of one or more virtual assets, according to an embodiment of the present invention;
- FIG 5: illustrates a flowchart 500 of a method for optimizing design of one or more virtual assets rendered in a computer-simulated environment such that the optimized design complies with safety condition for an industrial environment, according to an embodiment of the present invention;
- FIG 6: illustrates a flowchart 600 of a method for optimizing design of one or more virtual assets rendered in a computer-simulated environment, according to an embodiment of the present invention;
- FIG 7: illustrates a flowchart 700 of a method for optimizing design of one or more virtual assets rendered in a computer-simulated environment, according to an embodiment of the present invention; and
- FIG 8: illustrates a flowchart 800 of a method for automatically recommending design modifications of one or more virtual assets rendered in a computer-simulated environment using an AI module, according to an embodiment of the present invention;

Hereinafter, embodiments for carrying out the present invention are described in detail. The various embodiments are described with reference to the drawings, wherein like reference numerals are used to refer to like elements throughout. In the following description, for purpose of explanation, numerous specific details are set forth in order to provide a thorough understanding of one or more embodiments. It may be evident that such embodiments may be practiced without these specific details.

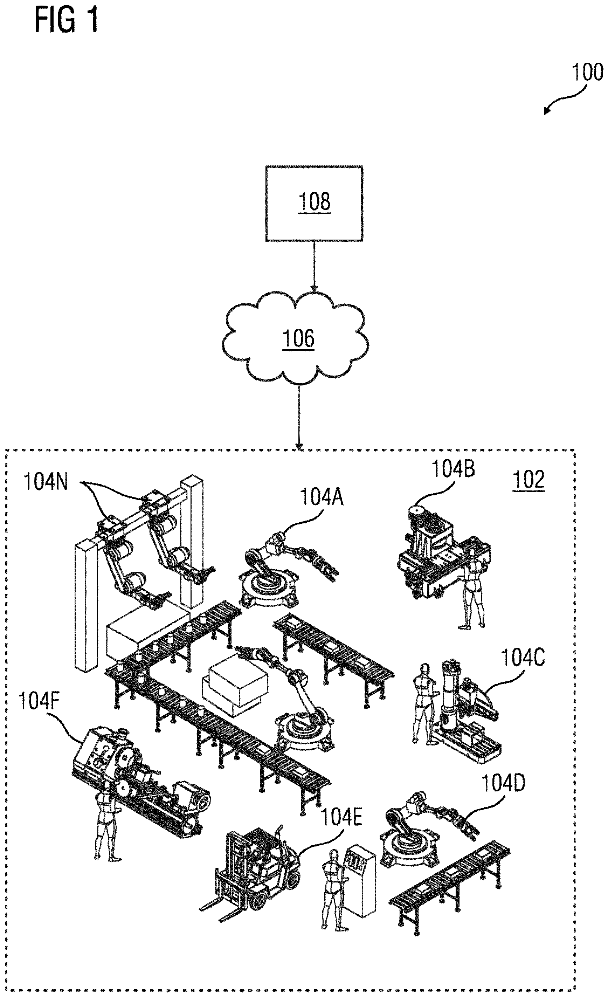

FIG 1 is a block diagram of a system 100 for optimizing design of one or more virtual assets (104a-104n) rendered in a computer-simulated environment 102 such that the optimized design complies with safety condition for an industrial environment. The system 100 comprises a computer simulated environment 102, one or more virtual assets (104a-104n) rendered in the computer simulated environment 102, an apparatus 108 communicating over a communication network 106. The computer simulated environment 102 is three-dimensional (3D) representation of a real or physical world. It can be understood as a virtual world representing one or more virtual assets (104a- 104n) of the real-world assets in an industrial environment. The term "industrial environment" as used herein refers to any industrial environment comprising one or more assets interacting therein. The term industrial environment may refer to any building such as a factory or any type of manufacturing facility, an office building or the like, which may be populated with various assets. Herein, the term "factory" or industrial environment refers to the whole of machineries or parts thereof which cooperate to allow a production process of any kind to be carried out. Example of factory may be any industrial set-up with a plurality of assets such as a power plant, wind farm, power grid, manufacturing facility, process plants and so on. Although the present disclosure has been described generally in terms of the industrial environment being some form of a factory floor, the term "industrial environment" as used in the preferred embodiments and claims according to the present disclosure should be understood broadly to include not only factory floors, but also other indoor facilities and buildings such as hospitals, office spaces, apartments, complexes, schools, training centers, and so forth. The term "industrial environment" may also include other outdoor facilities such as a parking lot, a traffic junction, and vehicles such as airplanes, ships and trucks.

Safety standards are to be maintained within the industrial environment to ensure the safety of the human users and to avoid accidents or mishaps. Therefore, it is important that the industrial environment is designed to adhere to the safety standards and offer a safe environment for the users within the industrial environment. The design of the industrial environment includes the different machines / equipment that the disposed, layout of the factory floor, storage of materials, and the like. In the proposed invention, the design of the industrial environment is validated using a digital replica of the industrial environment to ensure that the design does not violate any safety standards. Further, if there any safety violations are detected, then the design of the industrial environment is optimized by modifying the design of the one or more assets within the industrial environment. Thus, in the presented invention, the digital replica of the industrial environment is validated to ensure that the design meets the safety requirements and further the design of the digital replica of the industrial environment is modified to rectify the safety violations of the original design of the industrial environment.

The term "one or more virtual assets" refers to specific objects, elements, components, or subjects in an industrial environment. In an example, the one or more virtual assets (104a-104n) may be digital representation of assets, devices, machinery, robots, equipment, assembly lines, conveyors, motors, pumps, compressors, or any other mechanical, electrical, or electronic equipment, workers, operators, supervisors, in the industrial environment. In an example, the industrial environment is an office building, the one or more virtual assets (104a-104n) may be digital representation of desks, chairs, tables, cabinets, shelves, partitions, workstations, conference room furniture, lighting fixtures, or any other furniture or fixtures typically found in an office environment. Further, the one or more assets may be equipment, or systems used in office operations, including computers, printers, scanners, copiers, telephones, projectors, audio-visual systems, networking devices, or any other technological or electronic devices commonly used in an office setting. In another example, the facility is an airplane under maintenance, the one or more assets may be physical framework, body, or fuselage of the airplane, including wings, tail sections, landing gear, engine nacelles, cockpit, cabin, doors, windows, and any other structural components that contribute to the overall form and integrity of the aircraft, jet engines, turboprops, propellers, fuel systems, exhaust systems, thrust reversers, or any other elements involved in generating and controlling the aircraft's propulsion, electronic systems and instruments used for aircraft navigation, communication, monitoring, and control, including flight control systems, flight management systems, autopilot systems, navigation systems, communication systems, radar systems, or any other electronic devices or subsystems installed on the aircraft, seating arrangements, overhead compartments, lavatories, galley equipment, lighting systems, entertainment systems, safety equipment, passengers, pilots, crew members and so forth.

The one or more virtual assets (104a- 104n) are 3-dimensional models of assets that are implemented in the industrial environment. The rendered 3-dimensional models of the assets are imported as a simulation in the computer simulated environment 102.

The computer-simulated environment 102 is accessible by a user, i.e., it is accessible from the real/physical world. In particular, the computer-simulated environment 102 can be understood as the "metaverse". It is also possible to interact with the computer-simulated environment 102, i.e., to influence or use processes, components and/or functions in the computer-simulated environment 102. The user or the avatar may interact with the virtual assets rendered in the metaverse.

For example, it is possible that a user can access the computer-simulated environment 102 via an interface, e.g., a virtual reality (VR) or augmented reality (AR) interface. For the purpose of this invention, the metaverse is comprised of one or more animated scenes being rendered corresponding to the plurality of assets interacting in the industrial environment. The metaverse may comprise a plurality of computer-simulated components. The computer simulated components can for example be understood as a representation, in particular a 3D representation, of a real or physical component. A component can for example be a room, a building, an item, or an object. The computer-simulated component can have different functionalities/features, e.g., an access interface. The metaverse can be realized by a hosting environment. The hosting environment can be for example implemented as a cloud environment, an edge-cloud environment and/or on specific devices, e.g., mobile devices.

In one embodiment, the apparatus 108 is deployed in a cloud computing environment. As used herein, "cloud computing environment" refers to a processing environment comprising configurable computing physical and logical resources, for example, networks, servers, storage, applications, services, etc., and data distributed over the network, for example, the internet. The cloud computing environment provides on-demand network access to a shared pool of the configurable computing physical and logical computing resources. The apparatus 108 may include a processing unit 302, and a module for optimizing design of one or more virtual assets (104a-104n) rendered in a computer-simulated environment 102.

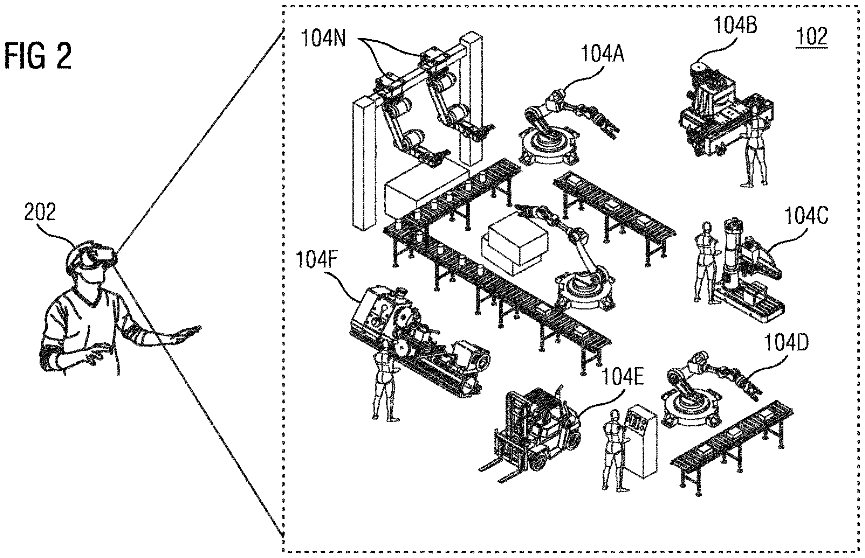

FIG 2 is an exemplary illustration of a user performing an operation in the computer simulated environment 102, according to an embodiment of the present invention. As may be seen, the user is equipped with a wearable device 202 configured for visualization of the simulation of one or more virtual assets (104a-104n) in the computer simulated environment 102. In an example, the wearable device 202 comprises a display module that presents visual information to the user, rendering one or more assets, in a realistic and immersive manner. The display module may include a high-resolution screen, holographic display, augmented reality (AR) glasses, or any other suitable technology for visually presenting virtual content to the user. Additionally, the wearable device 202 incorporates a tracking system to capture the user's movements and gestures, allowing for real-time interaction and navigation within the metaverse. The tracking system may utilize sensors, cameras, motion trackers, or any other suitable means of capturing and interpreting user movements. Furthermore, the wearable device 202 includes connectivity features to facilitate communication and data exchange with the metaverse infrastructure. These features may include wireless communication capabilities, such as Wi-Fi, Bluetooth, or cellular connectivity, enabling the wearable device 202 to connect to the metaverse platform, retrieve asset data, and transmit user actions or preferences. The wearable device 202 may also incorporate input mechanisms, such as touch-sensitive surfaces, buttons, voice recognition, or motion sensors, allowing users to provide commands, make selections, or manipulate virtual assets within the metaverse environment. The wearable device 202 for visualizing assets in the metaverse is designed to enhance the user's experience and immersion in the virtual world. It enables users to perceive, interact with, and navigate through virtual assets, objects, and environments seamlessly, thereby providing a novel and immersive way to explore and visualize digital content within the metaverse.

The users can interact with the virtual assets in the computer simulated environment to experience the functioning of the industrial environment. The users may perform operations on the virtual assets, wherein the operations performed on the virtual assets may be similar to the operations performed on the real physical assets deployed in the industrial environment. Thus, the system offers an immersive experience that is similar to the real-world scenario. As an example, the user may perform a welding operation on the virtual assets, wherein the user may interact with virtual model of welding machine to mimic the welding operation in the computer simulated environment. The user may notice that the hot fumes from the welding process enters a storage area where inflammable chemicals are placed. The user may suggest a design modification to relocate the storage area inflammable chemicals. Thus, the immersive experience provided to the user enables detecting design flaws and aids optimizing the design by getting inputs from the user.

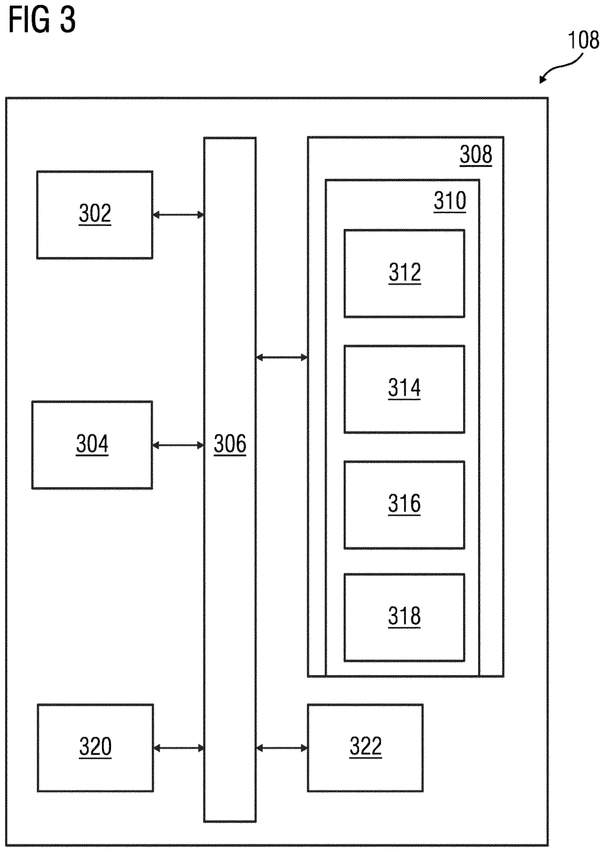

FIG 3 is a block diagram of an exemplary apparatus 108 for optimizing design of one or more virtual assets (104a-104n) rendered in a computer-simulated environment 102, according to an embodiment of the present invention. In an exemplary embodiment, the apparatus 108 is communicatively coupled to the computer simulated environment 102 rendering one or more assets.

The apparatus 108 may be a personal computer, a laptop computer, a tablet, a server, a virtual machine, and the like. The apparatus 108 includes a processing unit 302, a memory 308 comprising a module 310, a database 304, an input unit 320, a display unit 322 and a bus 306.

The processing unit 302 as used herein, means any type of computational circuit, such as, but not limited to, a microprocessor, microcontroller, complex instruction set computing microprocessor, reduced instruction set computing microprocessor, very long instruction word microprocessor, explicitly parallel instruction computing microprocessor, graphics processor, digital signal processor, or any other type of processing circuit. The processing unit 302 may also include embedded controllers, such as generic or programmable logic devices or arrays, application specific integrated circuits, single-chip computers, and the like.

The memory 308 may be non-transitory volatile memory and/or non-volatile memory. The memory may be coupled for communication with the processing unit 302, such as being a computer-readable storage medium. The processing unit 302 may execute instructions and/or code stored in the memory. A variety of computer-readable instructions may be stored in and accessed from the memory. The memory may include any suitable elements for storing data and machine-readable instructions, such as read only memory, random access memory, erasable programmable read only memory, electrically erasable programmable read only memory, a hard drive, a removable media drive for handling compact disks, digital video disks, diskettes, magnetic tape cartridges, memory cards, and the like.

In the present embodiment, the memory 308 includes the module stored in the form of machine-readable instructions on any of the above-mentioned storage media and may be in communication to and executed by the processing unit 302. When the machine-readable instructions are executed by the processing unit 302, the module causes the processing unit 302 to render one or more virtual assets (104a-104n) in the computer simulated environment 102.

The module 310 further comprises a rendering module 312, authentication module 314, interface module 316, and Artificial Intelligence (AI) module 318.

The rendering module 312 is configured for rendering one or more virtual assets (104a-104n) in the computer simulated environment 102. The rendering module 312 acquires the 3-dimensional computer models of assets that are deployed in the industrial environment. Further, the rendering module 312 renders the one or more virtual assets (104a-104n) to generate a simulation of the one or more virtual assets (104a-104n) in the computer simulated environment 102.

The authentication module 314 is configured to authenticate the user interacting with the computer simulated environment 102. The authentication module 314 is configured to receive an identifier from the user and may check for authenticity of the identifier and further grant access to the user to interact with the simulation in the computer simulated environment 102. The identifier may be a login credential uniquely associated with the user interacting in the computer simulated environment 102. Further, the authentication module 314 may also record the information about the users interacting with the computer simulated environment 102.

The interface module 316 is configured for providing a platform for the user to access the computer simulated environment 102. The interface module 316 may comprise hardware elements and software elements such as libraries that enable access to the computer simulated environment 102. In one embodiment, the interface module may be implemented as the wearable device 202 configured to provide a platform for interacting with the simulation.

The AI module 318 is configured for automatically detecting safety violations in the design of one or more virtual assets (104a-104n) and providing recommendations to optimize the design of the one or more virtual assets (104a-104n) to overcome the safety violations. The AI module 318 may be trained using a training dataset comprising historical data relating to safety standards and design standards associated with the industry. The AI module 318 may use machine learning algorithms for automatically detecting safety violations and recommending design modifications to overcome the safety violations.

The processing unit 302 is configured for performing all the functionality of the module. The processing unit 302 is configured for importing a simulation of one or more virtual assets (104a-104n) into the computer-simulated environment 102. The processing unit 302 is configured for enriching the simulation with data corresponding to safety standards associated with the industrial environment. The processing unit 302 is configured for defining a plurality of safety-simulation scenarios that are to be simulated in the computer-simulated environment 102 for validation of safety standards of the one or more virtual assets (104a-104n). The processing unit 302 is configured for executing the safety-simulation scenarios on the one or more virtual assets (104a-104n) in the computer-simulated environment 102 to determine safety violations associated with the one or more virtual assets (104a-104n). The processing unit 302 is configured for receiving one or more inputs from a user for optimizing the design of the one or more virtual assets (104a-104n) to overcome the determined safety violations. The processing unit 302 is configured for optimizing the design of one or more virtual assets (104a-104n) based on the input received from the user, wherein at least one design parameter of at least one virtual asset is modified to optimize the design of virtual assets to meet the safety standards of the industrial environment.

The database 304 may be configured for storing 3-dimensional computer models of assets that are deployed in an industrial environment. The database may be provided using various types of storage technologies, such as solid state drives, hard disk drives, flash memory, and may be stored in various formats, such as relational databases, non-relational databases, flat files, spreadsheets, and extended markup files, etc.

The input unit 320 may provide ports to receive input from input devices such as keypad, touch-sensitive display, camera (such as a camera receiving gesture-based inputs), etc. capable of receiving set of requirements for rendering a simulation of one or more virtual assets (104a-104n). The display unit 322 may provide ports to output data via output device with a graphical user interface for displaying one or more scenes in the computer simulated virtual environment. The bus acts as interconnection between the processing unit 302, the memory, the database, the input unit, and the display unit.

Those of ordinary skilled in the art will appreciate that the hardware depicted in FIG 3 may vary for particular implementations. For example, other peripheral devices such as an optical disk drive and the like, Local Area Network (LAN)/ Wide Area Network (WAN)/ Wireless (e.g., Wi-Fi) adapter, graphics adapter, disk controller, input/output (I/O) adapter also may be used in addition to or in place of the hardware depicted. The depicted example is provided for the purpose of explanation only and is not meant to imply architectural limitations with respect to the present disclosure.

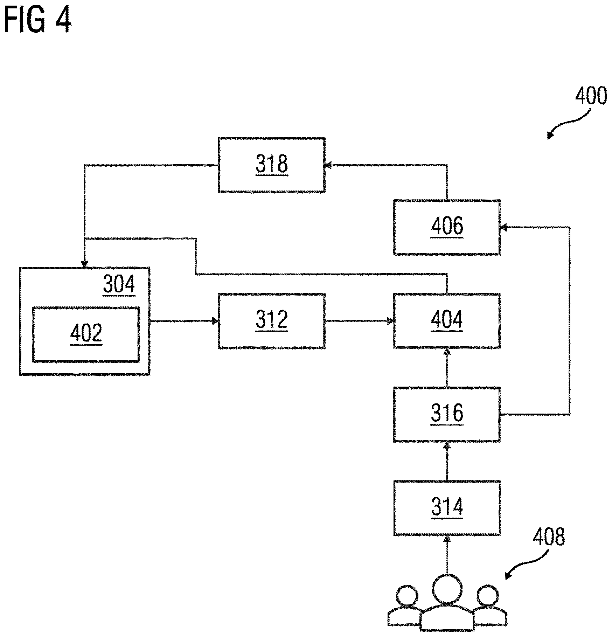

FIG. 4 illustrates an architecture 400 of the system 100 for optimizing design of one or more virtual assets (104a-104n), according to an embodiment of the present invention. The database may comprise design of one or more virtual assets (104a-104n) that are to be deployed in an industrial environment. The design may be in the form of 3-dimensional computer models representing the one or more assets deployed in the industrial environment.

The rendering module 312 is configured for retrieving the design 402 of one or more virtual assets (104a-104n) from the database 304. Further, the rendering module 312 may render the retrieved 3-dimensional models of virtual assets to generate a simulation 404 of the one or more virtual assets (104a-104n). The simulation 404 generated by the rendering module 312 enables the user to interact with the one or more virtual assets and offers an immersive experience. The rendering module 312 may employ physics engine to generate a simulation that mimics the real-world environment in the computer-simulated environment 102. As an example, the simulation 404 enables the user to perform operations that are performed in real-world environment such as operating a crane for lifting objects within the industrial environment. The simulation 404 that is generated by the rendering module 312 may then be stored in the database 304, wherein the simulation may be retrieved whenever required. The database 304 may be a decentralized database that may be shared by different users using the computer-simulated environment 102.

The authentication module 314 authenticates the identity of the user 408 and grants access to the user 408 to interact with the simulation of one or more virtual assets (104a-104n). The authentication module 314 may verify the user at least based on a unique identifier such as login credentials associated with the user.

Upon authentication of the user, the interface module 316 provides the platform for accessing the simulation by the user. The interface module 316 may be a combination of hardware and software elements that provides the platform wherein the user may interact with the simulation to perform operations in the computer simulated environment 102. The interface module 316 may include libraries such as ARCore, ARKit to provide a platform for accessing the simulation.

The user may provide inputs 406 as feedback after executing safety simulation scenarios in the simulation. The input 406 may relate to design modifications to be made to the one or more virtual assets (104a-104n) to overcome the safety violations of the one or more virtual assets (104a-104n). The inputs and the safety violations may further be stored in the database for reference.

The Artificial Intelligence (AI) module may receive the inputs received from the user and may provide recommendations to overcome the safety violations. The AI module 318 may be trained using a training dataset to identify safety violations in an industrial environment and provide appropriate recommendations to overcome the safety violations. The recommendations provided by the AI module 318 along with the corresponding safety violations may be stored in the database for future reference.

Further, in a scenario where the AI module 318 is not adequately trained to provide recommendations for overcoming the determined safety violations, the AI module is configured for self-learning by training on the input provided by the user and design modifications made to the one or more virtual assets (104a-104n).

In one embodiment, the AI module 318 is configured for validating the inputs received from the user to verify if the design modifications corresponding to the inputs provided by the user may result in safety violations in the industrial environment. Therefore, the input received from the user is scrutinized to ensure that the input received from the user does not result in safety violations.

In one embodiment, the AI module 318 may further comprise a classifier configured for classifying the input received from the user. The classifier receives the input from the user and determines whether the input received from the user corresponds to a minor modification to the virtual assets or a major modification to the virtual assets. If the input received from the user corresponds to a minor modification, then the AI module 318 may automatically make the design modifications to the one or more virtual assets. If the input received from the user corresponds to a major modification, then the AI module 318 may recommend the user to manually modify the design of one or more virtual assets.

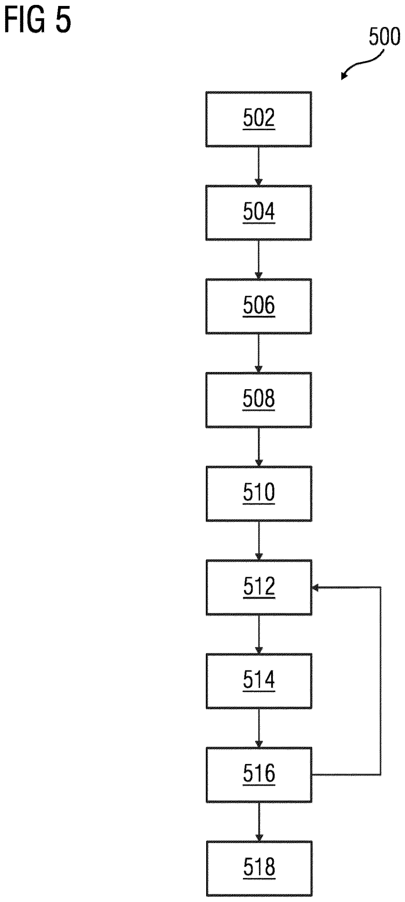

FIG. 5 is a flowchart 500 of a method for optimizing design of one or more virtual assets (104a-104n) rendered in a computer-simulated environment 102 such that the optimized design complies with safety condition for an industrial environment, according to an embodiment of the present invention. At step 502, the 3-dimensional computer models of the one or more assets are retrieved by the processing unit 302. The 3-dimensional computer models of the assets may be stored in the database and retrieved from the database when required.

At step 504, the simulation of the one or more virtual assets (104a-104n) is imported into the computer simulated environment 102 by the processing unit 302. The rendering module 312 may generate a simulation of the virtual assets by rendering the 3-dimensional computer models of the assets. Further, the simulation may be stored in the database which may further be imported into the computer simulated environment 102 by the processing unit 302.

At step 506, the simulation is enriched with the data corresponding to safety standards associated with the industrial environment. The data that is used to enrich the simulation may be real-time data and historical data obtained from the factory floor using sensors.

At step 508, a plurality of safety-simulation scenarios that are to be simulated in the computer-simulated environment 102 for validation of safety standards of the one or more virtual assets (104a-104n) are defined by the processing unit 302. In one embodiment, the processing unit 302 may utilize historical data associated with the industry to define the safety simulation scenarios within the industrial environment. In another embodiment, a set of safety simulation scenarios may be pre-defined by the user for the industry associated with the industrial environment. As an example, safety simulation scenario may be determining obstructions to industrial shopfloor equipment.

At step 510, the safety-simulation scenarios are executed by the processing unit 302 on the one or more virtual assets (104a-104n) in the computer-simulated environment 102 to determine safety violations associated with the one or more virtual assets (104a-104n). In one embodiment, the processing unit 302 may automatically execute the safety simulation scenarios to determine the safety violations associated with the one or more virtual assets (104a-104n). In another embodiment, the user may perform safety simulation scenarios in the computer simulated environment 102 to determine the safety violations associated with the one or more virtual assets (104a-104n).

At step 512, the processing unit 302 receives input from the user for optimizing the design of the one or more virtual assets (104a-104n) to overcome the determined safety violations. The user may provide the inputs in the form of annotations, text, or gestures in the computer simulated environment 102. The input may correspond to design modifications to be made to the one or more virtual assets (104a-104n) to overcome the safety violations.

At step 514, the design of one or more virtual assets (104a-104n) is optimized by the processing unit 302 based on the input received from the user. The processing unit 302 may identify at least one design parameter to be modified to optimize the design of virtual assets to meet the safety standards of the industrial environment. The design parameter may be orientation of the one or more assets in the industrial environment, positioning of one or more virtual assets (104a-104n) in the industrial environment so on and so forth.

At step 516, the safety simulation scenarios are performed on the optimized virtual assets to detect whether the optimized design of virtual assets has safety violations. The optimized virtual assets are subject to safety simulation scenarios to determine any new safety violations that arise due to the design modification of the one or more virtual assets (104a-104n).

If no safety violations are detected with the optimized design of virtual assets, then, at step 518, the optimized design is finalized by the processing unit 302.

If safety violations are detected in the optimized design, then the safety violations are shared with the user and the method goes to step 512, wherein the processing unit 302 receives input from the user to overcome the detected safety violations. This design optimization is repeated until no safety violations are detected in the one or more virtual assets (104a-104n).

An example scenario for optimizing the design of one or more virtual assets (104a-104n) rendered in a computer-simulated environment 102 such that the optimized design complies with safety condition for a steel factory is presented. The 3-dimensional models of all the equipment and machinery deployed in a steel factory is rendered to generate a simulation of the steel factory. Further, live sensor data from the steel factory is supplemented to the simulation to make the simulation a digital twin of the steel factory. The user may interact with the simulation and perform safety simulation scenarios within the simulation. For example, the user may operate a crane carrying molten metal within the factory. As per safety standards, there must be a minimum distance between two cranes in a steel factory to ensure that the cranes do not collide. The user or the processing unit 302 may detect that there is a safety violation, wherein the distance between two cranes in the factory does not meet safety standards of the industry. The user may provide inputs or feedback to overcome the safety violation by providing new coordinates for positioning the cranes so that the cranes do not collide. The processing unit 302 using an AI module 318, processes the input and optimizes the design of the factory floor by changing the position of the cranes. Thus, any safety violations associated with the design of the industrial environment shall be detected using a simulation and corrective measures shall be made to the design to overcome the safety violations.

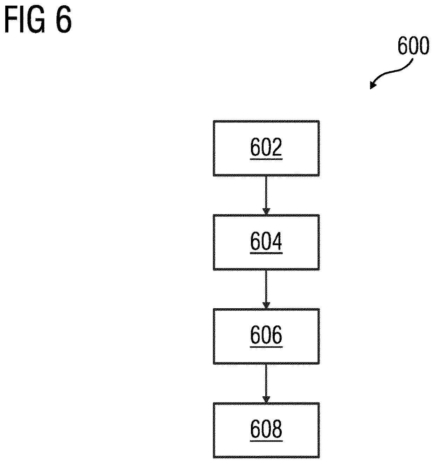

FIG. 6 is a flowchart 600 of a method for optimizing design of one or more virtual assets (104a-104n) rendered in a computer-simulated environment 102, according to an embodiment of the present invention. At step 602, the safety simulation scenarios are executed on the one or more virtual assets (104a-104n) by the user interacting with the computer-simulated environment 102. The user may perform certain parts of the safety simulation scenarios that are executed on the one or more virtual assets (104a-104n). The user may also remain as an observer, observing the safety-simulation scenarios that are performed on the one or more virtual assets (104a-104n).

At step 604, the user validates the safety violations that are automatically detected by the processing unit 302. The user may determine whether the safety violations determined by the processing unit 302 is authentic or not using their knowledge and expertise in the domain. The processing unit 302 may learn from the outcomes of the user validation to train the AI module 318 to automatically detect the safety violations. The user may detect any wrongful determination of safety violations associated with one or more virtual assets (104a-104n) in the computer-simulated environment 102.

At step 606, the inputs are received from the user to optimize the design of one or more virtual assets (104a-104n) to overcome determined safety violations. The inputs may relate to design changes to be made to the one or more virtual assets (104a-104n).

At step 608, the design of one or more virtual assets (104a-104n) is optimized by the processing unit 302 based on the input received from the user. The processing unit 302 may identify at least one design parameter to be modified to optimize the design of virtual assets to meet the safety standards of the industrial environment. As an example, the design parameter may be orientation of the one or more assets in the industrial environment, positioning of one or more virtual assets (104a-104n) in the industrial environment so on and so forth.

As an example, the processing unit may determine a presence of object A in an area B to be safety violation. The safety violation is presented to the user for validation to determine if the detected safety violation is authentic or not. If the user provides an input that presence of object A in area B is not a safety violation, the processing unit receives the input and declassifies the safety violation. Further, this information is used to train the AI module 318 for automatically determining the safety violations associated with one or more virtual assets. Thus, an additional check is made by the user to validate the safety violations that are automatically determined by the processing unit.

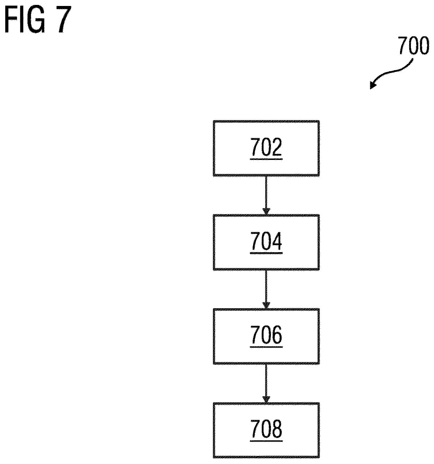

FIG. 7 is a flowchart 700 of a method for optimizing design of one or more virtual assets (104a-104n) rendered in a computer-simulated environment 102, according to an embodiment of the present invention. At step 702, an operation is performed by the user on one or more virtual assets (104a-104n) in the computer simulated environment 102. The operation that is performed may be any safety related operation that is typically associated with the industrial environment, or a normal day-to-day operation performed in the industrial environment.

At step 704, one or more inputs from the user corresponding to the performed operation for optimizing the design of the one or more virtual assets (104a-104n) is received by the processing unit 302. The inputs may relate to design modifications to be made to the one or more virtual assets (104a-104n). The input may be general modification and need not be modification due to safety violations.

At step 706, the processing unit 302 validates the inputs received from the user to determine safety violations associated with the design modifications corresponding to the inputs received from the user. In other words, if a user proposes a design modification as an input, the processing unit 302 receives the input and checks whether the proposed design modification to the one or more virtual assets (104a-104n) would result in a safety violation. Thus, a validation of input received from the user ensures that the resultant design modification does not result in a safety violation.

At step 708, the design of one or more virtual assets (104a-104n) is optimized based on the input received from the user if no safety violations are determined. If the proposed design modifications do not result in safety violations, then the design of one or more virtual assets (104a-104n) is optimized based on the input received from the user.

As an example, the processing unit may determine a safety violation wherein a machine X comes in contact with machine Y when machine X is operated. The user may provide an input for overcoming the safety violation, wherein the input may correspond to moving machine X to a new coordinate. The processing unit may receive the input and check if the movement of machine X to the new coordinate would result in a new safety violation. For example, if the machine X is moved to the new coordinate, a portion of the machine X may extend into traffic lane. Therefore, the processing unit may determine that the input received from the user may result in a safety violation and may notify the user that the input may result in a safety violation. If moving the machine X to the new coordinate does not result in a safety violations, the processing unit optimizes the design by modifying the design of one or more virtual assets to overcome the safety violations.

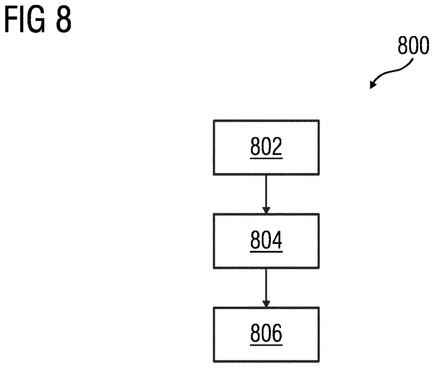

FIG. 8 is a flowchart 800 of a method for automatically recommending design modifications of one or more virtual assets (104a-104n) rendered in a computer-simulated environment 102 using an AI module 318, according to an embodiment of the present invention. At step 802, the processing unit 302 analyzes the one or more inputs received from the user to validate the input with an AI module 318.

The AI module 318 validates the input to determine recommendations to overcome safety violations associated with one or more virtual assets (104a-104n). The AI module 318 may be trained with training dataset comprising design modifications made to one or more virtual assets (104a-104n) and safety violations associated with the one or more virtual assets (104a-104n).

At step 804, the AI module 318 generates recommendations for modifications to be made to the virtual assets to overcome safety violations, if the AI module 318 is trained with adequate training data. If the AI module 318 is trained with the training dataset that comprises data corresponding to the detected safety violation associated with the one or more virtual asset, the AI module 318 may automatically generate recommendations for modifying the design of one or more virtual asset to overcome the safety violation.

At step 806, if the AI module 318 does not have recommendations, wherein the training dataset does not comprise data corresponding to the detected safety violation associated with the one or more virtual asset, the AI module 318 may learn and train using the inputs received from the user. The AI module 318 may record the inputs received from the user and corresponding design modifications made to the one or more virtual assets (104a-104n). Thus, the AI module 318 may learn and suggest design modifications in future when encountered with similar safety violation.

The present invention is advantageous by enabling detection of safety violations in a design of an industrial environment even before the practical implementation of the industrial environment. Therefore, it offers cost benefits and reduces human effort involved in correcting design flaws resulting in safety violations after installation of the industrial environment.

While the invention has been illustrated and described in detail with the help of a preferred embodiment, the invention is not limited to the disclosed examples. Other variations can be deducted by those skilled in the art without leaving the scope of protection of the claimed invention.

### List of references

- 100: system for optimizing design of one or more virtual assets rendered in a computer-simulated environment
- 102: Computer simulated environment
- 104a to 104n: Virtual assets
- 106: Communication network
- 108: Apparatus
- 202: Wearable device
- 302: Processing unit
- 304: Database
- 306: Bus
- 308: Memory
- 310: Module
- 312: rendering module
- 314: authentication module
- 316: interface module
- 318: AI module
- 320: Input unit
- 322: Display unit
- 400: architecture of the system for optimizing design of one or more virtual assets
- 500: flowchart of a method for optimizing design of one or more virtual assets rendered in a computer-simulated environment
- 600: flowchart of a method for optimizing design of one or more virtual assets rendered in a computer-simulated environment
- 700: flowchart of a method for optimizing design of one or more virtual assets rendered in a computer-simulated environment
- 800: flowchart of a method for automatically recommending design modifications of one or more virtual assets rendered in a computer-simulated environment using an AI module

## Claims

1. A computer-implemented method for optimizing design of one or more virtual assets (104a-104n) rendered in a computer-simulated environment (102) such that the optimized design complies with safety condition for an industrial environment, wherein the method comprises:
importing, by a processing unit (302), a simulation of one or more virtual assets (104a-104n) into the computer-simulated environment (102);
enriching, by the processing unit (302), the simulation with data corresponding to safety standards associated with the industrial environment;
defining, by the processing unit (302), a plurality of safety-simulation scenarios that are to be simulated in the computer-simulated environment (102) for validation of safety standards of the one or more virtual assets (104a-104n);
executing, by the processing unit (302), the safety-simulation scenarios on the one or more virtual assets (104a-104n) in the computer-simulated environment (102) to determine safety violations associated with the one or more virtual assets (104a-104n);
receiving, by the processing unit (302), one or more inputs from a user for optimizing the design of the one or more virtual assets (104a-104n) to overcome the determined safety violations; and
optimizing, by the processing unit (302), the design of one or more virtual assets (104a-104n) based on the input received from the user, wherein at least one design parameter of at least one virtual asset (104a-104n) is modified to optimize the design of virtual assets (104a-104n) to meet the safety standards of the industrial environment.

2. The method according to claim 1, wherein receiving one or more inputs from a user for optimizing the design comprises:
interacting, by the user, with the computer-simulated environment (102), to execute the safety-simulation scenarios on the one or more virtual assets (104a-104n) in the computer-simulated environment (102); and
validating, by the user, the determined safety violations to provide one or more inputs for optimizing the design of one or more virtual assets (104a-104n) to overcome determined safety violations.

3. The method according to any of the preceding claims, wherein the method comprises:
executing, by the processing unit (302), the safety-simulation scenarios on the optimized virtual assets (104a-104n) in the computer-simulated environment (102) to determine safety violations; and
optimizing, by the processing unit (302), the design of the one or more virtual assets (104a-104n) to overcome determined safety violations by receiving inputs from the user until no safety violation is detected.

4. The method according to any of the preceding claims, wherein the method comprises:
performing, by the user, an operation on the one or more virtual assets (104a-104n) in the computer-simulated environment (102);
receiving, by the processing unit (302), one or more inputs from the user corresponding to the performed operation for optimizing the design of the one or more virtual assets (104a-104n);
validating, by the processing unit (302), inputs received from the user to determine safety violations in the design modifications corresponding to the inputs received; and
optimizing, by the processing unit (302), the design of one or more virtual assets (104a-104n) based on the input received from the user if no safety violations are determined.

5. The method according to any of the preceding claims, wherein the one or more virtual assets (104a-104n) of the computer-simulated environment (102) comprise 3-dimensional computer models of the physical assets that are deployed in the industrial environment.

6. The method according to any of the preceding claims, wherein the method comprises:
authenticating, by the processing unit (302), the user based on a unique identifier associated with the user before providing the user the access to interact with the computer-simulated environment (102).

7. The method according to any of the preceding claims, wherein the simulation of the one or more virtual assets (104a- 104n) is generated by retrieving and rendering 3-dimensional computer models of assets deployed in the industrial environment.

8. The method according to any of the preceding claims, wherein the method comprises:
analyzing, by the processing unit (302), the one or more inputs received from the user to validate the input with an AI module (318);
recommending, by the processing unit (302) using the AI module (318), a modification to be made to the virtual assets (104a-104n) to overcome safety violations, if the AI module (318) is trained with adequate training data; and
training, the AI module (318), using the inputs received from the user and the modifications made to the design of one or more virtual assets (104a-104n), if the AI module (318) does not have a recommendation for the inputs received from the user.

9. The method according to any of the preceding claims, wherein the method comprises:
determining, by the processing unit (302), the modification to be made to the virtual assets (104a-104n) to overcome safety violations by correlating the safety violations with a repository of safety standards, and design standards stored in a memory (308).

10. An apparatus (108) for optimizing design of one or more virtual assets (104a-104n) rendered in a computer-simulated environment (102) such that the optimized design complies with safety standards defined for an industrial environment, the apparatus (108) comprising:
one or more processing units (302);
a memory (308) communicatively coupled to the one or more processing units (302), the memory (308) comprising a module (310) stored in the form of machine-readable instructions executable by the one or more processing units (302), wherein the module (310) is configured to perform the method steps according to claims 1 to 9.

11. A system (100) for optimizing design of one or more virtual assets (104a-104n) rendered in a computer-simulated environment (102) such that the optimized design complies with safety standards defined for an industrial environment, the system comprising:
a computer-simulated environment (102) comprising the one or more one or more virtual assets (104a- 104n);
a communication network (106) communicatively coupled to the computer-simulated environment (102); and
an apparatus (108) according to claim 8, communicatively coupled to the communication network (106) and the computer-simulated environment (102), wherein the apparatus (108) is configured for optimizing design of one or more virtual assets (104a-104n) rendered in the computer-simulated environment (102) such that the optimized design complies with safety standards defined for an industrial environment, according to any of the method claims 1 to 9.

12. A computer-program product, having computer-readable instructions stored therein, that when executed by a processing unit (302), cause the processing unit (302) to perform method steps according to any of the claims 1 to 9.

13. A computer readable medium on which program code sections of a computer program are saved, the program code sections being loadable into and/or executable in a system to make the system execute the method steps according to any of the claims 1 to 9 when the program code sections are executed in the system.
